# EUROPÄISCHE PATENTSCHRIFT

(11) **EP 4 607 214 B1**
(45) Veröffentlichungstag und Bekanntmachung des Hinweises auf die Patenterteilung: **09.12.2026**
(21) Anmeldenummer: 24158646.0
(22) Anmeldetag: 20.02.2024
(51) Int. Cl.: G01R 31/367, G01R 31/382, G01R 31/3842, G01R 31/392, G01R 31/396

(54) **VERFAHREN ZUR ERMITTLUNG EINES LADUNGSDURCHSATZES EINER BATTERIEZELLE**
METHOD FOR DETERMINING A CHARGE THROUGHPUT OF A BATTERY CELL
PROCÉDÉ DE DÉTERMINATION D'UN DÉBIT DE CHARGE D'UN ÉLÉMENT DE BATTERIE

(43) Veröffentlichungstag der Anmeldung: 27.08.2025
(73) Patentinhaber: Siemens Aktiengesellschaft, 80333 München (DE)
(72) Erfinder: Fischer, Michael, 91320 Ebermannstadt (DE); Arzberger, Arno, 96135 Stegaurach (DE); Katzer, Felix, 90763 Fürth (DE); Radinger, Hannes, 90459 Nürnberg (DE); Winterstein, Heiko, 91325 Adelsdorf (DE)
(74) Vertreter: Siemens Patent Attorneys

(56) Entgegenhaltungen:
- EP-A1- 1 505 402
- DE-A1- 102020 103 179
- DE-A1- 102020 201 508
- US-A1- 2016 178 706

## Beschreibung

Die Erfindung betrifft ein Verfahren gemäß dem Oberbegriff des Patentanspruches 1 sowie eine HPC-Verfahren gemäß dem Oberbegriff des Patentanspruches 9.

Batteriezellen können mittels verschiedener Kenngrößen charakterisiert werden. Allerdings weisen die genannten Kenngrößen je nach Zelltyp, Betriebsbedingungen und Produktionsqualität deutliche Unterschiede auf. Wichtige Kenngrößen sind insbesondere die Lebensdauer sowie die Selbstentladungsrate einer Batteriezelle.

Die Lebensdauer einer Batteriezelle kennzeichnet die Rate des Verlusts an nutzbarer Kapazität über die Zeit und/oder über die Betriebszyklen hinweg.

Die Selbstentladungsrate einer Batteriezelle kennzeichnet die Rate des Verlusts der mittels der Zelle gespeicherten Energie, ohne dass diese Energie extern genutzt wurde.

Typischerweise führen die Lebensdauer und die Selbstentladungsrate erst über vergleichsweise großen Zeitskalen zu messbaren Änderungen. Für praktische Untersuchungen und Bewertungen von Batteriezellen ist es hingegen wichtig, die genannten Kenngrößen innerhalb eines möglichst kurzen Zeitraums zu ermitteln.

Zur Reduzierung der Testdauer von Lebensdauer- und Selbstentladungsmessungen wird im Stand der Technik auf beschleunigte Tests zurückgegriffen, die bei höheren Temperaturen und gegebenenfalls höheren Stromstärken durchgeführt werden. Dadurch kann eine beschleunigte Alterung und Selbstentladungen der Batteriezelle provoziert werden. Allerdings stellen diese Testbedingungen nicht das Verhalten der Batteriezelle unter typischen und damit relevanten Betriebsbedingungen dar.

Weitere bekannte Verfahren zur Ermittlung der genannten Kenngrößen verwenden eine höhere Genauigkeit, um so kleinere Änderungen bereits auf kurzen Zeitskalen zu erfassen. Ein solches Verfahren ist die High Precision Coulometry (HPC-Verfahren), mittels welchem der Batteriezelle entnommene und/oder ihr zugeführte Ladungsmengen sehr genau erfasst werden können.

Das HPC-Verfahren macht sich zu Nutze, dass der Ladezustand einer Batteriezelle (englisch: State of Charge; SOC) im Zusammenhang mit der Ruhespannung der Batteriezelle steht. Beim HPC-Verfahren wird zwischen zwei definierten Ladezuständen zyklisiert, wobei die definierten Ladezustände mit entsprechenden festgelegten Ruhespannungen zusammenhängen. Das HPC-Verfahren misst die Ladungsmengen während der einzelnen Ladezyklen und Entladezyklen. Dadurch können die Coulombic Efficiency (CE) und/oder geringe Kapazitätsverluste innerhalb weniger Zyklen erfasst werden. Hieraus ergeben sich schließlich Aussagen über die Selbstentladungsrate und die Lebensdauer der Batteriezelle.

Nachteilig an bekannten HPC-Verfahren ist, dass aufgrund der bei der Messung verwendeten Stromstärken es zu kinetischen Effekten innerhalb der Batteriezelle kommen kann. Dadurch ist die an der Batteriezelle erfasste Spannung verschieden von ihrer Ruhespannung. Der genannte Unterschied zwischen der erfassten Spannung und der Ruhespannung der Batteriezelle wird als Überspannung bezeichnet. Die Überspannung kann sich innerhalb des HPC-Verfahrens von Zyklus zu Zyklus ändern, sodass die Voraussetzung des HPC-Verfahrens verletzt ist, dass die Testzyklen zwischen gleichbleibenden Ladezuständen durchgeführt werden. Aus DE 102020103179 A1 ist ein Verfahren zur Ermittlung der Kapazität von Batteriezellen bekannt, bei dem ein Ladungsdurchsatz durch eine Vorrichtung ermittelt und Differenzwerte ΔSOC gebildet werden. Aus DE 102020201508 A1 ist ein Verfahren zur Ermittlung der Kapazität einer Batteriezelle bekannt, bei dem die Kapazität der Batteriezelle mittels eines Korrekturfaktors sowie mathematischer Modelle, die auf Ladungsdurchsatzwerten und einer Ladezustandsdifferenz zwischen zwei unterschiedlichen Zeitpunkten basieren, ermittelt wird. Aus EP 1505402 A1 ist ein Verfahren zur Bestimmung einer elektrischen Kenngröße (z. B. des Zustands) einer Batteriezelle bekannt, bei dem Ladezustandsunterschiedswerte (ΔSOC₁, ΔSOC₂) und eine ladungsbezogene Ruhespannungsänderung ΔQ ermittelt werden.

Der vorliegenden Erfindung liegt die Aufgabe zugrunde, ein Verfahren zur verbesserten Ermittlung von Ladungsdurchsätzen, insbesondere im Rahmen eines HPC-Verfahrens, bereitzustellen.

Die Aufgabe wird durch ein Verfahren mit den Merkmalen des unabhängigen Patentanspruches 1 sowie durch ein HPC-Verfahren mit den Merkmalen des unabhängigen Patentanspruches 9 gelöst. In den abhängigen Patentansprüchen sind vorteilhafte Ausgestaltungen und Weiterbildungen der Erfindung angegeben.

Bei dem erfindungsgemäßen Verfahren zur Ermittlung wenigstens eines Ladungsdurchsatzes ΔQ' einer Batteriezelle, insbesondere im Rahmen eines HPC-Verfahrens, wird wenigstens ein mit zwei festgelegten Spannungswerten *V*₁, *V*₂ assoziierter Ladungsunterschied Δ*Q* erfasst, wobei für die Batteriezelle zwei Sollwerte bezüglich ihrer Ruhespannung *V*ₘᵢₙ, *V*ₘₐₓ und zwei zu den Sollwerten der Ruhespannung *V*ₘᵢₙ, *V*ₘₐₓ zugehörige Sollwerte von Ladezuständen SOCₘᵢₙ, SOCₘₐₓ festgelegt sind. Das Verfahren ist gekennzeichnet durch wenigstens folgende Schritte:
- Abschalten des Stromes bei einem Erreichen des jeweiligen Spannungswertes *V*₁, *V*₂;
- Ermitteln der jeweiligen Ruhespannung basierend auf einem durch das Abschalten des Stromes induzierten jeweiligen Abklingverhalten der Spannung;
- Ermitteln eines jeweiligen Spannungsunterschieds Δ*V*₁*,* Δ*V*₂ zwischen der jeweiligen ermittelten Ruhespannung und ihrem jeweils zugehörigen Sollwert *V*ₘᵢₙ, *V*ₘₐₓ;
- Ermitteln eines zum jeweiligen Spannungsunterschied Δ*V*₁*,* Δ*V*₂ zugehörigen jeweiligen Ladezustandsunterschieds ΔSOC₁, ΔSOC₂; und
- Ermitteln des Ladungsdurchsatzes Δ*Q*' in Abhängigkeit des erfassten Ladungsunterschieds Δ*Q* und der ermittelten Ladezustandsunterschiede ΔSOC₁, ΔSOC₂.

Ohne Einschränkung des Schutzumfanges wird im Weiteren *V*₁ *> V*₂ angenommen. Mit anderen Worten erfolgt gemäß des Verfahrens innerhalb eines Zyklus wenigstens ein Beladen oder Entladen der Batteriezelle zwischen den Spannungswerten *V*₁, *V₂,* sodass damit ein Ladungsdurchsatz Δ*Q* assoziiert ist.

Weiterhin sind für die Batteriezelle zwei Sollwerte bezüglich ihrer Ruhespannung *V*ₘᵢₙ, *V*ₘₐₓ und zwei zu den Sollwerten der Ruhespannung *V*ₘᵢₙ, *V*ₘₐₓ zugehörige Sollwerte von Ladezuständen SOCₘᵢₙ, SOCₘₐₓ festgelegt. Die genannten Ruhespannungen sowie die zugehörigen Ladezustände können für das Verfahren bereitgestellt werden. Insbesondere können die genannten Sollwerte mittels einer Ruhespannungskennlinie der Batteriezelle bereitgestellt werden.

Gemäß dem erfindungsgemäßen Verfahren wird der Ladungsdurchsatz Δ*Q* zwischen den Spannungswerten *V*₁, *V*₂ erfasst. Mit anderen Worten wird erfasst, welche Ladungsmenge der Batteriezelle zwischen den genannten zwei Spannungswerten dieser zugeführt beziehungsweise dieser abgeführt wird. Die erfasste Ladungsmenge beziehungsweise der erfasste Ladungsdurchsatz Δ*Q* entspricht jedoch aufgrund von Überspannungen, die durch die endliche Stromstärke induziert sind, nicht dem Ladungsdurchsatz, der sich bei Verwendung der tatsächlichen Ruhespannungen ergeben würde. Die vorliegende Erfindung sieht daher eine Korrektur des Ladungsdurchsatzes vor, das heißt es wird der neue, korrigierte Ladungsdurchsatz Δ*Q*' aus dem erfassten Ladungsdurchsatz ermittelt. Zur Ermittlung des korrigierten Ladungsdurchsatzes Δ*Q*' weist das erfindungsgemäße Verfahren wenigstens die obenstehend genannten fünf Schritte auf.

In einem ersten Schritt des Verfahrens wird der Strom beim Erreichen des jeweiligen Spannungswertes *V*₁, *V*₂ abgeschaltet.

Mit anderen Worten ist die Batteriezelle, wenigstens für einen Zeitbereich, ab den genannten Spannungswerten stromlos. Es wird somit beim Erreichen der Spannungsgrenzen *V*₁ und/oder *V*₂ sozusagen eine Pause eingelegt, in welcher kein Strom durch die Batteriezelle fließt. Die Spannung wird jedoch bevorzugt ebenfalls in diesen stromfreien Zeitbereichen weiterhin erfasst beziehungsweise gemessen.

Gemäß einem zweiten Schritt des Verfahrens wird die jeweilige Ruhespannung basierend auf einem durch das Abschalten des Stromes induzierten jeweiligen Abklingverhalten der Spannung ermittelt.

Mit anderen Worten wird der Strom beim Erreichen der Spannungsgrenzwerte *V*₁, *V*₂ abgeschaltet, wodurch jeweils ein Abklingverhalten der Spannung induziert wird. Das jeweilige Abklingverhalten steht in Zusammenhang mit der jeweiligen Ruhespannung. Das ist deshalb der Fall, da bei einem ausreichend langen Abschalten des Stromes, das heißt bei einem ausreichend langen stromlosen Zeitbereich, die Spannung vom jeweiligen Spannungswert *V*₁, *V*₂ auf die jeweilige Ruhespannung abklingen würde. Mit anderen Worten wird die jeweilige Ruhespannung asymptotisch erreicht. Es ist somit vorliegend nicht erforderlich tatsächlich bis zum Erreichen der jeweiligen Ruhespannung abzuwarten, sondern die jeweilige Ruhespannung wird bereits aus dem erfassten Abklingverhalten ermittelt. Ein längeres Abwarten bis zum Erreichen der tatsächlichen Ruhespannungen kann jedoch ebenfalls vorgesehen sein.

Mit anderen Worten baut sich innerhalb der Pause (stromloser Zeitbereich) die Überspannung ab, sodass sich nach genügend langer Wartezeit die Ruhespannung der Batteriezelle einstellen würde. Damit ist die Ruhespannung der individuellen Batteriezelle im aktuellen Zustand genau messbar und es ist nicht erforderlich diese mittels weiteren Messparametern und/oder Modellen abzuschätzen. Dabei ist es erfindungsgemäß bereits ausreichend aus dem Abklingverhalten der jeweiligen Überspannung die jeweilige Ruhespannung zu ermitteln. Ein Abwarten bis die Überspannung nahezu vollständig abgeklungen ist, ist somit erfindungsgemäß nicht erforderlich.

In einem dritten Schritt des Verfahrens wird ein jeweiliger Spannungsunterschied Δ*V*₁*,* Δ*V*₂ zwischen der jeweiligen ermittelten Ruhespannung und ihrem jeweils zugehörigen Sollwert *V*ₘᵢₙ, *V*ₘₐₓ ermittelt. Mit anderen Worten wird ein Spannungsunterschied zwischen der ermittelten beziehungsweise erfassten Ruhespannung und der vorab festgelegten Ruhespannung ermittelt. Mit anderen Worten erfolgt eine Korrektur der Ruhespannungen, die durch die Spannungsunterschiede Δ*V*₁*,* Δ*V*₂ quantifiziert ist. Werden die erfassten beziehungsweise aus dem Abklingverhalten ermittelten Ruhespannungen als *V*_{OCV,min}, *V*_{OCV,max} bezeichnet, so ist *V*_{OCV,min} = *V*ₘᵢₙ - Δ*V*₂ und *V*_{OCV,max} = *V*ₘₐₓ - Δ*V*₁ und somit *V*_{OCV,max} = *V*₁ - *η*₁ beziehungsweise *V*_{OCV,min} = *V*₂ - *η*₂, wobei *η*₁, *η*₂ die jeweilige Überspannung bezeichnet.

Gemäß einem vierten Schritt des Verfahrens wird ein zum jeweiligen Spannungsunterschied Δ*V*₁*,* Δ*V*₂ zugehöriger jeweiliger Ladezustandsunterschied ΔSOC₁, ΔSOC₂ ermittelt. Bevorzugt erfolgt dies mittels einer Ruhespannungskennline der Batteriezelle. Weiterhin können dadurch die zu den tatsächlichen Ruhespannungen zugehörigen Ladezustände mittels SOCₘᵢₙ - ΔSOC₂ und SOCₘₐₓ - ΔSOC₁ berechnet werden.

Die Ladezustände sind per Definition proportional zur gespeicherten Ladungsmenge. Sie stehen somit in Zusammenhang mit den messbaren Ladungsmengen bei der Entladung beziehungsweise Ladung der Batteriezelle. Würde man die Ladungsmengen beim Erreichen der jeweiligen Spannungsgrenzen *V*₁, *V*₂ messen, so wäre beispielsweise die im Rahmen eines bekannten HPC-Verfahrens ermittelte Ladungsmenge der Entladestufe, welche dem Entladeverlauf von SOCₘₐₓ bis SOCₘᵢₙ zuzuschreiben, die erfasste Ladungsmenge Δ*Q*. Durch das erfindungsgemäße Verfahren, welche die tatsächliche Ruhespannungen über das jeweilige Abklingverhalten innerhalb der stromfreien Zeitbereiche ermittelt, zeigt sich für das genannten Ausführungsbeispiel, dass es sich tatsächlich um einen Entladeverlauf von SOCₘₐₓ - ΔSOC₁ bis SOCₘᵢₙ - ΔSOC₂ handelte. Somit ist mittels des Verfahrens in Abhängigkeit der ermittelten Ladezustandsunterschiede ΔSOC₁, ΔSOC₂ sowie des erfassten Ladungsunterschieds ΔQ eine Korrektur möglich, wodurch ein genaueres Verfahren zur Ermittlung des Ladungsdurchsatzes und somit insbesondere ein genaueres HPC-Verfahren bereitgestellt wird. Diese Korrektur des erfassten Ladungsunterschieds Δ*Q* wird in einem fünften Schritt des Verfahrens durchgeführt.

Gemäß des fünften Schrittes des Verfahrens wird somit der Ladungsdurchsatz Δ*Q*' in Abhängigkeit des erfassten Ladungsunterschieds ΔQ und der ermittelten Ladezustandsunterschiede ΔSOC₁, ΔSOC₂ ermittelt. Beispielsweise kann hierzu eine in den Ladezustandsunterschieden ΔSOC₁, ΔSOC₂ lineare Korrektur, welche für hinreichend kleine Spannungsunterschiede Δ*V*₁*,* Δ*V₂,* gültig ist, verwendet werden.

Das erfindungsgemäße Verfahren stellt somit eine Methode bereit, mittels welcher die während jedes Ladezyklus und Entladezyklus messbaren Ladungsmengen auf eine gemeinsame Referenz, beispielsweise den Verlauf von SOCₘₐₓ bis SOCₘᵢₙ, umgerechnet werden können. Da bekannte HPC-Verfahren konstante Zustände an den Grenzen der Testzyklen voraussetzen, können die umgerechneten, das heißt gemäß dem Verfahren korrigierten Ladungsmengen beziehungsweise Ladungsdurchsätze, vorteilhafterweise für ein HPC-Verfahren verwendet werden. Dadurch wird vorteilhafterweise die Genauigkeit bekannter HPC-Verfahren verbessert.

Mit anderen Worten setzen bekannte HPC-Verfahren voraus, dass der Innenwiderstand beziehungsweise die Überspannung hinreichend genau und stets aktuell über vorhandene Modelle in Kombination mit im Test verfügbaren Messdaten bestimmt werden kann. Allerdings können zum einen Messungenauigkeiten von elektrischen und thermischen Parametern die Bestimmung des Innenwiderstands verfälschen. Zum anderen können Schwankungen der Zellqualität und eine Alterung der Batteriezelle die für die Berechnung angenommen Widerstandsmodelle abändern und damit indirekt zu falschen Widerstandswerten führen.

Kommt es zu Schwankungen von Δ*V*₁*,* Δ*V*₂ im Verlaufe der Testzyklen aufgrund der genannten Fehler, dann weisen die Ladezustände an den Grenzen des Testzyklus keinen festen Bezug mehr zueinander auf. Dadurch ist jedoch die Grundvoraussetzung zur Auswertung der Ladungsmengen im Rahmen bekannter HPC-Verfahren verletzt. Das erfindungsgemäße Verfahren beziehungsweise das erfindungsgemäße HPC-Verfahren ermöglichen jedoch weiterhin ein genaues und konsistentes Verfahren.

Das ist deshalb der Fall, da das erfindungsgemäße Verfahren die Ruhespannung, bei dem insbesondere eine Ruhephase ohne Stromzufuhr verwendet wird, die Ruhespannung zum jeweils aktuellen Zeitpunkt und individuell für die jeweils verwendete Batteriezelle ermittelt. Daher ist dieses Verfahren von den zuvor beschriebenen Fehlereinflüssen unabhängig und es sind zudem keine Modelle des jeweiligen Batteriezelletyps erforderlich.

Durch die über die Ruhespannung bestimmten Ladezustände werden die gemessenen Ladungsmengen beziehungsweise Ladungsdurchsätze korrigiert, sodass diese zwischen den einzelnen Zyklen vergleichbar bleiben. Somit lassen sich insbesondere Schwankungen der Überspannung, welche durch äußere und innere Einwirkungen, beispielsweise Temperaturfluktuationen, zwischen den einzelnen Testzyklen auftreten können, herausrechnen beziehungsweise korrigieren. Bei bekannten Verfahren erfolgt dies mittels komplexer Modelle und fehleranfälligen Messungen. Weiterhin ermöglicht das erfindungsgemäße Verfahren auch dann ein Ermitteln von Ladungsdurchsätzen und somit ein HPC-Verfahren, wenn die Batteriezelle nicht im thermodynamischen Gleichgewicht mit ihrer Umgebung ist.

Das erfindungsgemäße HPC-Verfahren für eine Batteriezelle, bei dem wenigstens eine Lebensdauer der Batteriezelle ermittelt wird, ist gekennzeichnet dadurch, dass für eine Ermittlung der Lebensdauer ein Kapazitätsverlust der Batteriezelle durch ein mehrfaches Ermitteln eines Ladungsdurchsatzes Δ*Q*' gemäß der vorliegenden Erfindung und/oder einer ihrer Ausgestaltungen ermittelt wird.

Es ergeben sich zum erfindungsgemäßen Verfahren gleichartige, gleichwertige und gleichwirkende Vorteile und/oder Ausgestaltungen des erfindungsgemäßen HPC-Verfahrens.

Gemäß einer vorteilhaften Ausgestaltung der Erfindung wird der Ladungsdurchsatz Δ*Q*' mittels eines Korrekturfaktors *K* gemäß Δ*Q*' = Δ*Q*/*K*(Δ*SOC*₁*,* ΔSOC₂|SOCₘₐₓ, SOCₘᵢₙ) ermittelt.

Mit anderen Worten erfolgt eine Korrektur des Ladungsdurchsatzes Δ*Q*' beziehungsweise im Rahmen eines HPC-Verfahrens eine mehrfache Korrektur des hierbei erfassten Ladungsdurchsatzes mittels eines Korrektur, die proportional zum jeweiligen erfassten Ladungsdurchsatz Δ*Q* ist. Somit erfolgt die Korrektur mittels einer Skalierung des erfassten Ladungsdurchsatzes, das heißt mittels eines Korrekturfaktors, der von den ermittelten Ladezustandsunterschieden ΔSOC₁, ΔSOC₂ sowie den festgelegten Sollwerten SOCₘₐₓ, SOCₘᵢₙ abhängig ist.

In einer besonders bevorzugten Weiterbildung der Erfindung wird der Ladungsdurchsatz ΔQ' mittels $Δ Q ′ = Δ Q / \left[1+\frac{Δ {SOC}_{1} - Δ {SOC}_{2}}{{SOC}_{max} - {SOC}_{min}}\right] ,$ ermittelt.

Mit anderen Worten ist $K \left(Δ{SOC}_{1},Δ{SOC}_{2}\left|{SOC}_{max}, {SOC}_{min}\right.\right) = 1 + \frac{Δ {SOC}_{1} - Δ {SOC}_{2}}{{SOC}_{max} - {SOC}_{min}}$ sodass der Korrekturfaktor linear von den ermittelten Ladezustandsunterschieden ΔSOC₁, ΔSOC₂ abhängig ist. Mit anderen Worten erfolgte hierbei eine lineare Näherung des Korrekturfaktors, die für kleine Spannungsunterschiede Δ*V*₁*,* Δ*V*₂ ausreichend genau ist.

Gemäß einer vorteilhaften Ausgestaltung der Erfindung erfolgt das Ermitteln der Ladezustandsunterschiede ΔSOC₁, ΔSOC₂ mittels einer Ruhespannungskennlinie der Batteriezelle.

Die Ruhespannungskennlinie einer Batteriezelle kennzeichnet grundsätzlich den Zusammenhang zwischen dem Ladezustand der Batteriezelle und ihrer zum genannten Ladezustand zugehörigen Ruhespannung. Mit anderen Worten ist *V*_{OCV} = *F*(SOC), wobei *V*_{OCV} die Ruhespannung, SOC den Ladezustand und *F* die Ruhespannungskennline bezeichnet. Die Ruhespannungskennlinie ist typischerweise nichtlinear. Mittels der Ruhespannungskennlinie können somit durch Ausbilden der inversen Funktion *F*⁻¹ aus den ermittelten Spannungsunterschieden Δ*V*₁*,* Δ*V*₂ die zugehörigen Ladezustandsunterschiede ΔSOC₁, ΔSOC₂ ermittelt werden. Die Ruhespannungskennline beziehungsweise die inverse Ruhespannungskennlinie können in Form eines Diagramms, in Form von Tabellenwerten und/oder als analytischer Zusammenhang bereitgestellt werden.

In einer bevorzugten Weiterbildung der Erfindung werden die Ruhespannungen jeweils mittels eines Fit des Abklingverhaltens ermittelt.

Mit anderen Worten wird der Verlauf der Spannung nach dem Abschalten des Stromes wenigstens in einem festgelegten Zeitbereich erfasst und mittels einer Fitfunktion gefittet. Aus dem Fit kann die Ruhespannung ermittelt werden, ohne dass diese tatsächlich in der Messung erreicht wurde. Mit anderen Worten ist vorteilhafterweise das Abklingverhalten bereits ausreichend, den asymptotischen Wert der Ruhespannung mittels des Fits (Kurvenanpassung) zu ermitteln. Dadurch ist ein zu langes Abwarten vorteilhafterweise nicht erforderlich, sodass der Zeitbereich der stromlosen Phase möglichst klein festgelegt werden kann. Insbesondere wird der Strom beziehungsweise die Stromstärke für 1 bis 60 Sekunden, 1 bis 30 Sekunden oder 1 bis 10 Sekunden abgeschaltet.

Gemäß einer vorteilhaften Ausgestaltung der Erfindung wird *F*(*V*,*λ*|*t*) = *V*_{OCV} + (*v* - *V*_{OCV})exp (-*λt*) als Fitfunktion verwendet, wobei *V*_{OCV} die jeweilige zu ermittelnde Ruhespannung bezeichnet und *v*, *λ* weitere Fitparameter sind.

Dadurch wird vorteilhafterweise eine besonders genaue Ermittlung der tatsächlichen beziehungsweise der zu ermittelnden Ruhespannung *V*_{OCV} ermöglicht.

In einer vorteilhaften Weiterbildung der Erfindung wird der Strom über einen Zeitbereich von 1 bis 60 Sekunden, 1 bis 30 Sekunden oder 1 bis 10 Sekunden abgeschaltet.

Die genannten Zeitbereiche sind deshalb von Vorteil, da innerhalb dieser ein ausreichend genauer Fit des Abklingverhaltens erreicht werden kann und weiterhin ein zu langes Abwarten verhindert wird. Dadurch wird das Verfahren, insbesondere ein HPC-Verfahren, nicht unnötig zeitlich verlängert, sondern ein synergetisches Optimum zwischen Genauigkeit und Zeitdauer erreicht.

Weiterhin ist es vorteilhaft den stromlosen Zeitbereich beziehungsweise seine Dauer in Abhängigkeit einer Abklingkonstante des Abklingverhaltens festzulegen. Wird beispielsweise die Fitfunktion *F*(*V,λ*|*t*) = *V*_{OCV} + (*v* - *V*_{OCV})exp (-*λt*) verwendet, so entspricht der Fitparameter *λ* der genannten Abklingkonstanten. Die Abklingkonstante entspricht einer charakteristischen Abklingzeit 1/*λ*. Es ist somit vorteilhaft, den stromlosen Zeitbereich beziehungsweise seine Dauer in Abhängigkeit von 1/*λ* festzulegen.

Gemäß einer vorteilhaften Ausgestaltung der Erfindung ist die Batteriezelle als Lithium-Ionen-Batteriezelle ausgebildet.

Das erfindungsgemäße Verfahren ist für Lithium-Ionen-Batteriezellen deshalb von Vorteil, da diese typischerweise eine relevante Änderung ihrer Ruhespannung mit der Stromstärke, insbesondere im Rahmen eines HPC-Verfahrens, aufweisen.

In einer vorteilhaften Weiterbildung der Erfindung wird weiterhin eine Selbstentladung der Batteriezelle im Rahmen des HPC-Verfahrens ermittelt.

Vorteilhafterweise kann dadurch die Selbstentladung der Batteriezelle genauer ermittelt werden. Hierbei kann die Selbstentladung mittels der Dauer eines oder mehrerer Zyklen und des jeweiligen gemäß der vorliegenden Erfindung ermittelten Ladungsdurchsatzes ermittelt werden.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: ein Ablaufdiagramm eines Verfahrens gemäß einer Ausgestaltung der Erfindung;
- Figur 2: ein Spannungs-Zeit-Diagramm; und
- Figur 3: eine Ruhespannungskennline.
Gleichartige, gleichwertige oder gleichwirkende Elemente können in einer der Figuren oder in den Figuren mit denselben Bezugszeichen versehen sein.

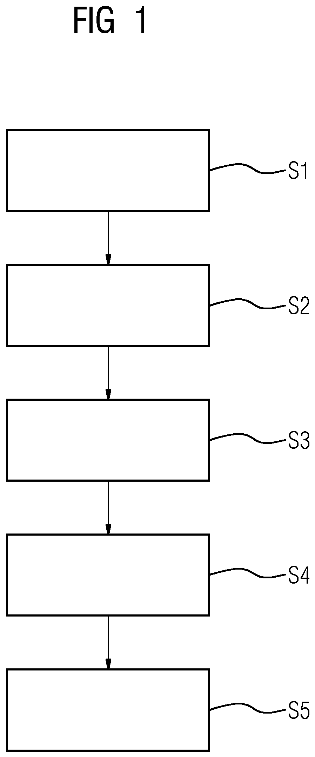

Die Figur 1 zeigt ein Ablaufdiagramm eines Verfahrens zur Ermittlung wenigstens eines Ladungsdurchsatzes Δ*Q*' einer Batteriezelle gemäß einer Ausgestaltung der vorliegenden Erfindung.

Gemäß dem Verfahren kann der Ladungsdurchsatz ebenfalls mehrfach hintereinander innerhalb von zeitlichen Zyklen, insbesondere im Rahmen eines HPC-Verfahrens, ermittelt werden.

Für das Beladen beziehungsweise Entladen der Batteriezelle werden zugehörige Spannungswerte *V*₁, *V*₂ festgelegt. Beispielsweise wird die Batteriezelle bis zum ersten Spannungswert *V*₁ geladen und/oder bis zum zweiten Spannungswert *V*₂ entladen. Die Differenz der zu den Spannungswerten *V*₁, *V*₂ zugehörigen Ladungen bildet den erfassten Ladungsunterschied Δ*Q* aus.

Weiterhin weist die Batteriezelle zwei Sollwerte bezüglich ihrer Ruhespannung *V*ₘᵢₙ, *V*ₘₐₓ und zwei zu den Sollwerten der Ruhespannung *V*ₘᵢₙ, *V*ₘₐₓ zugehörige Sollwerte von Ladezuständen SOCₘᵢₙ, SOCₘₐₓ auf, die für das Verfahren bereitgestellt werden und somit vorab festgelegt sind. Bevorzugt ist *V*₁ > *V*ₘₐₓ sowie *V*₂ < *V*ₘᵢₙ.

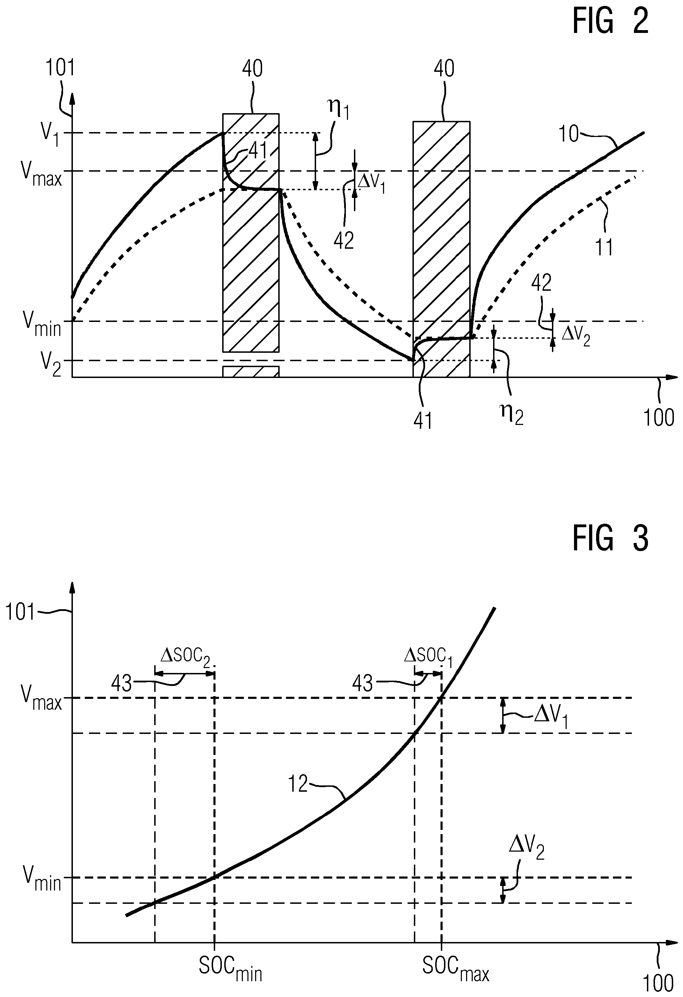

Gemäß einem ersten Schritt S1 des Verfahrens wird der Strom beziehungsweise die Stromstärke bei einem Erreichen des jeweiligen Spannungswertes *V*₁, *V*₂ abgeschaltet. Hierbei wird der Strom für einen festgelegten Zeitbereich abgeschaltet, beispielsweise für 1 bis 60 Sekunden, insbesondere für 1 bis 10 Sekunden. Diese Pausen bezüglich der Stromstärke sind in der folgenden Figur 2 durch das Bezugszeichen 40 symbolisiert. Mit anderen Worten wird die Batteriezelle so lange geladen, bis der erste Spannungswert *V*₁ erreicht ist. Hierzu kann die Spannung in diskreten zeitlichen Abständen, quasi kontinuierlich und/oder kontinuierlich erfasst werden. Durch das Abschalten des Stromes beziehungsweise der Stromstärke in den Zeitbereichen 40 wird ein Abklingverhalten 41 der Spannung induziert. Mit anderen Worten verringert sich dadurch Spannung asymptotisch auf die zum Ladezustand zugehörige Ruhespannung der Batteriezelle.

In einem zweiten Schritt S2 des Verfahrens wird somit die jeweilige Ruhespannung basierend auf dem durch das Abschalten des Stromes induzierten jeweiligen Abklingverhalten 41 der Spannung ermittelt. Hierzu ist es nicht erforderlich bis zum Erreichen der Ruhespannung abzuwarten, sondern diese kann durch einen Fit bereits aus dem Abklingverhalten 41 ermittelt werden. Dadurch kann der stromfreie Zeitbereich 40 möglichst kurz sein beziehungsweise verkürzt werden. Der Unterschied zwischen den Spannungswerten und den jeweiligen Ruhespannungen bildet die sogenannte jeweilige Überspannung aus. Die jeweiligen Überspannungen sind in der Figur 2 mit dem Symbol *η*₁ beziehungsweise *η*₂ gekennzeichnet.

Weiterhin bilden sich Spannungsunterschiede Δ*V*₁*,* Δ*V*₂ zwischen den festgelegten Ruhespannungen *V*ₘₐₓ beziehungsweise *V*ₘᵢₙ und den tatsächlichen Ruhespannungen *V*_{OCV,max}, *V*_{OCV,min} aus, die mittels des Abklingverhaltens 41 ermittelt wurden. Mit anderen Worten ist *V*_{OCV,min} = *V*ₘᵢₙ - Δ*V*₂ und *V*_{OCV,max} = *V*ₘₐₓ - Δ*V*₁ und somit *V*_{OCV,max} = *V*₁ *- η*₁ beziehungsweise *V*_{OCV,min} = *V*₂ - *η*₂.

Gemäß einem dritten Schritt S3 des Verfahrens werden somit die genannten jeweiligen Spannungsunterschiede Δ*V*₁*,* Δ*V*₂ zwischen der jeweiligen ermittelten Ruhespannung und ihrem jeweils zugehörigen Sollwert *V*ₘᵢₙ, *V*ₘₐₓ ermittelt. Die Spannungsunterschiede sind in der Figur 2 mit dem Bezugszeichen 42 gekennzeichnet.

In einem vierten Schritt S4 des Verfahrens werden zum jeweiligen Spannungsunterschied Δ*V*₁*,* Δ*V*₂ zugehörige jeweilige Ladezustandsunterschiede ΔSOC₁, ΔSOC₂ ermittelt. Dies erfolgt mittels einer Ruhespannungskennlinie der Batteriezelle, die die Abhängigkeit der Ruhespannung vom Ladezustand der Batteriezelle beschreibt. Für das Ermitteln der Ladezustandsunterschiede aus den Spannungsunterschieden wird somit die in den jeweiligen Bereichen inverse Ruhespannungskennlinie verwendet, das heißt aus den Spannungsunterschieden Δ*V*₁*,* Δ*V*₂ von den Spannungswerten *V*ₘₐₓ, *V*ₘᵢₙ werden mittels der Ruhespannungskennlinie beziehungsweise ihrer Inversen die Ladezustandsunterschiede von den festgelegten Ladezuständn SOCₘᵢₙ, SOCₘₐₓ ermittelt (vgl. Figur 3).

Gemäß einem fünften Schritt S5 des Verfahrens wird der Ladungsdurchsatz Δ*Q*' in Abhängigkeit des erfassten Ladungsunterschieds ΔQ und der ermittelten Ladezustandsunterschiede ΔSOC₁, ΔSOC₂ ermittelt. Mit anderen Wort wird der erfasste Ladungsdurchsatz Δ*Q* korrigiert, wobei die Korrektur insbesondere deshalb vorteilhaft ist, da sich grundsätzlich innerhalb der Zyklen aufgrund der Stromstärke eine Überspannung einstellt. Der mittels den Ladezustandsunterschieden ΔSOC₁, ΔSOC₂ korrigierte Ladungsdurchsatz Δ*Q*' berücksichtigt somit dieses Verhalten. Dadurch wird ein genaueres Verfahren zur Ermittlung des Ladedurchsatzes beziehungsweise ein genaueres und somit verbessertes HPC-Verfahren bereitgestellt.

Besonders bevorzugt wird im oben genannten Sinne der erfasste Ladungsdurchsatz ΔQ gemäß $Δ Q ′ = Δ Q / \left[1+\frac{Δ {SOC}_{1} - Δ {SOC}_{2}}{{SOC}_{max} - {SOC}_{min}}\right]$ korrigiert.

In der Figur 2 ist das bereits unter Figur 1 beschriebene Verfahren mittels eines Spannung-ZeitDiagramms symbolisch dargestellt.

An der Abszisse 100 des Diagramms ist die Zeit in beliebigen Einheiten aufgetragen. An der Ordinate 101 des Diagramms ist die Spannung, die erfasst wird, in beliebigen Einheiten aufgetragen.

Weiterhin ist in der Figur 2 die erfasste Spannung in Form eines Spannungsverlaufes 10 dargestellt. Entsprechend ist die tatsächliche Ruhespannung der Batteriezelle ebenfalls als zeitlicher Ruhespannungsverlauf 11 (gestrichelte Linie) dargestellt.

Die Batteriezelle wird zunächst bis zu einem festgelegten Spannungswert beziehungsweise einer festgelegten Spannungsgrenze *V*₁ geladen. Anschließend wird der Strom beziehungsweise die Stromstärke innerhalb des Zeitbereiches 40 abgeschaltet, wodurch die Spannung ein Abklingverhalten 41 aufweist. Allerdings stimmt aufgrund einer Überspannung *η*₁ die Spannung *V*₁ nicht mit der Ruhespannung der Batteriezelle überein. Mit anderen Worten bildet sich zwischen der festgelegten Ruhespannung *V*ₘₐₓ und der tatsächlichen Ruhespannung ein Spannungsunterschied Δ*V*₁ aus. Analog bildet sich beim Entladen der Batteriezelle aufgrund einer Überspannung *η*₂ ein Spannungsunterschied Δ*V*₂ zwischen der festgelegten Ruhespannung *V*ₘᵢₙ und der tatsächlichen Ruhespannung aus. Die Spannungsunterschiede Δ*V*₁*,* Δ*V*₂ sind in der Figur 2 mit dem Bezugszeichen 42 gekennzeichnet.

In der Figur 3 ist eine Ruhespannungskennline 12 der Batteriezelle dargestellt.

An der Abszisse 100 des Diagramms ist der Ladezustand der Batteriezelle in beliebigen Einheiten aufgetragen. An der Ordinate 101 des Diagramms ist die Ruhespannung in beliebigen Einheiten aufgetragen.

Die Ruhespannungskennlinie 12 verdeutlicht, dass mit jedem Ladezustand der Batteriezelle eine Ruhespannung assoziiert ist. Umgekehrt ist mit jeder Ruhespannung ein Ladezustand assoziiert.

Durch die ermittelten Spannungsunterschiede Δ*V*₁*,* Δ*V*₂ können somit mittels des Diagramms beziehungsweise mittels der Ruhespannungskennlinie die zugehörigen Ladezustandsunterschiede ΔSOC₁, ΔSOC₂ 43 ermittelt werden. Dieses Ermitteln ist im Diagramm durch die gestrichelten Linien symbolisiert. Aus den ermittelten Ladezustandsunterschieden ΔSOC₁, ΔSOC₂ kann wiederum der bezüglich der erfassten Ladungsunterschieds ΔQ korrigierte Ladedurchsatz ΔQ' ermittelt werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- S1: erster Schritt
- S2: zweiter Schritt
- S3: dritter Schritt
- S4: vierter Schritt
- S5: fünfter Schritt

- 10: Spannungsverlauf
- 11: Ruhespannungsverlauf
- 12: Ruhespannungskennline
- 40: Abschalten des Stromes
- 41: Abklingverhalten
- 42: Spannungsunterschiede
- 43: Ladezustandsunterschiede

- 100: Abszisse
- 101: Ordinate

## Patentansprüche

1. Verfahren zur Ermittlung wenigstens eines Ladungsdurchsatzes Δ*Q*' einer Batteriezelle, insbesondere im Rahmen eines HPC-Verfahrens, bei dem ein mit zwei festgelegten Spannungswerten *V*₁, *V*₂ assoziierter Ladungsunterschied Δ*Q* erfasst wird, wobei für die Batteriezelle zwei Sollwerte bezüglich ihrer Ruhespannung *V*ₘᵢₙ, *V*ₘₐₓ und zwei zu den Sollwerten der Ruhespannung *V*ₘᵢₙ, *V*ₘₐₓ zugehörige Sollwerte von Ladezuständen SOCₘᵢₙ, SOCₘₐₓ festgelegt sind, **gekennzeichnet durch** folgende Schritte:
- (S1) Abschalten des Stromes (40) bei einem Erreichen des jeweiligen Spannungswertes *V*₁, *V*₂;
- (S2) Ermitteln der jeweiligen Ruhespannung basierend auf einem **durch** das Abschalten des Stromes induzierten jeweiligen Abklingverhalten (41) der Spannung;
- (S3) Ermitteln eines jeweiligen Spannungsunterschiedes Δ*V*₁*,* Δ*V*₂ (42) zwischen der jeweiligen ermittelten Ruhespannung und ihrem jeweils zugehörigen Sollwert *V*ₘᵢₙ, *V*ₘₐₓ;
- (S4) Ermitteln eines zum jeweiligen Spannungsunterschied Δ*V*₁*,* Δ*V*₂ zugehörigen jeweiligen Ladezustandsunterschieds ΔSOC₁, ΔSOC₂ (43); und
- (S5) Ermitteln des Ladungsdurchsatzes Δ*Q*' in Abhängigkeit des erfassten Ladungsunterschieds Δ*Q* und der ermittelten Ladezustandsunterschiede ΔSOC₁, ΔSOC₂ (43).

2. Verfahren gemäß Anspruch 1, **gekennzeichnet dadurch, dass** der Ladungsdurchsatz Δ*Q*' mittels eines Korrekturfaktors *K* gemäß Δ*Q*' *=* Δ*Q*/*K*(Δ*SOC*₁, ΔSOC₂|SOCₘₐₓ, SOCₘᵢₙ) ermittelt wird.

3. Verfahren gemäß Anspruch 1 oder 2, **gekennzeichnet dadurch, dass** der Ladungsdurchsatz ΔQ' mittels $Δ Q ′ = Δ Q / \left[1+\frac{Δ {SOC}_{1} - Δ {SOC}_{2}}{{SOC}_{max} - {SOC}_{min}}\right] ,$ ermittelt wird.

4. Verfahren gemäß einem der vorhergehenden Ansprüche, **gekennzeichnet dadurch, dass** das Ermitteln der Ladezustandsunterschiede ΔSOC₁, ΔSOC₂ (43) mittels einer Ruhespannungskennlinie (13) der Batteriezelle erfolgt.

5. Verfahren gemäß einem der vorhergehenden Ansprüche, **gekennzeichnet dadurch, dass** die Ruhespannungen jeweils mittels eines Fit des Abklingverhaltens (41) ermittelt werden.

6. Verfahren gemäß Anspruch 5, **gekennzeichnet dadurch, dass** *F*(*V*, *λ*|*t*) = *V*_{OCV} + (*v* - *V*_{OCV})exp (-*λt*) als Fitfunktion verwendet wird, wobei *V*_{OCV} die jeweilige zu ermittelnde Ruhespannung bezeichnet und *v*, *λ* weitere Fitparameter sind.

7. Verfahren gemäß einem der vorhergehenden Ansprüche, **gekennzeichnet dadurch, dass** der Strom über einen Zeitbereich von 1 bis 60 Sekunden, 1 bis 30 Sekunden oder 1 bis 10 Sekunden abgeschaltet wird.

8. Verfahren gemäß einem der vorhergehenden Ansprüche, **gekennzeichnet dadurch, dass** die Batteriezelle als Lithium-Ionen-Batteriezelle ausgebildet ist.

9. HPC-Verfahren für eine Batteriezelle, bei dem wenigstens eine Lebensdauer der Batteriezelle ermittelt wird, **gekennzeichnet dadurch, dass** für eine Ermittlung der Lebensdauer ein Kapazitätsverlust der Batteriezelle durch ein mehrfaches Ermitteln eines Ladungsdurchsatzes Δ*Q*' gemäß einem der vorhergehenden Ansprüche ermittelt wird.

10. HPC-Verfahren gemäß Anspruch 9, **gekennzeichnet dadurch, dass** weiterhin eine Selbstentladung der Batteriezelle ermittelt wird.

## Claims

1. Method for ascertaining at least one charge throughput ΔQ' of a battery cell, in particular in the context of an HPC method, in which a charge difference ΔQ associated with two defined voltage values V₁, V₂ is detected, wherein, for the battery cell, two setpoint values with respect to the open-circuit voltage Vₘᵢₙ, Vₘₐₓ thereof and two setpoint values of states of charge SOCₘᵢₙ, SOCₘₐₓ associated with the setpoint values of the open-circuit voltage Vₘᵢₙ, Vₘₐₓ are defined, **characterized by** the following steps:
- (S1) switching off the current (40) when the respective voltage value V₁, V₂ is reached;
- (S2) ascertaining the respective open-circuit voltage on the basis of a respective decay behaviour (41) of the voltage induced by the switching off of the current;
- (S3) ascertaining a respective voltage difference ΔV₁, ΔV₂ (42) between the respective ascertained open-circuit voltage and the respective associated setpoint value Vₘᵢₙ, Vₘₐₓ thereof;
- (S4) ascertaining a respective state of charge difference ΔSOC₁, ΔSOC₂ (43) associated with the respective voltage difference ΔV₁, ΔV₂; and
- (S5) ascertaining the charge throughput ΔQ' on the basis of the detected charge difference ΔQ and the ascertained state of charge differences ΔSOC₁, ΔSOC₂ (43).

2. Method according to Claim 1, **characterized in that** the charge throughput ΔQ' is ascertained by means of a correction factor K according to ΔQ' = ΔQ/K(ΔSOC₁,ΔSOC₂ | SOCₘₐₓ, SOCₘᵢₙ) .

3. Method according to Claim 1 or 2, **characterized in that** the charge throughput ΔQ' is ascertained by means of $ΔQ ′ = ΔQ / \left[1+\frac{Δ {SOC}_{1} - Δ {SOC}_{2}}{{SOC}_{max} - {SOC}_{min}}\right]$.

4. Method according to any one of the preceding claims, **characterized in that** the state of charge differences ΔSOC₁, ΔSOC₂ (43) are ascertained by means of an open-circuit voltage characteristic curve (13) of the battery cell.

5. Method according to any one of the preceding claims, **characterized in that** the open-circuit voltages are each ascertained by means of a fit of the decay behaviour (41).

6. Method according to Claim 5, **characterized in that** F(V,λ|t) = V_{OCV} + (v-V_{OCV})exp(-λt) is used as the fit function, where V_{OCV} denotes the respective open-circuit voltage to be ascertained and v, λ are additional fit parameters.

7. Method according to any one of the preceding claims, **characterized in that** the current is switched off over a period of 1 to 60 seconds, 1 to 30 seconds or 1 to 10 seconds.

8. Method according to any one of the preceding claims, **characterized in that** the battery cell is in the form of a lithium-ion battery cell.

9. HPC method for a battery cell, in which at least a lifetime of the battery cell is ascertained, **characterized in that**, to ascertain the lifetime, a loss in capacity of the battery cell is ascertained by repeatedly ascertaining a charge throughput ΔQ' according to any one of the preceding claims.

10. HPC method according to Claim 9, **characterized in that** a self-discharge of the battery cell is also ascertained.

## Revendications

1. Procédé d'établissement d'au moins un débit Δ*Q*' de charge d'un élément de batterie, en particulier dans le cadre d'un procédé HPC, dans lequel on détecte une différence Δ*Q* de charge associée à deux valeurs *V*₁, *V*₂ fixées de la tension, dans lequel on fixe pour l'élément de batterie deux valeurs de consigne associées à sa tension Vₘᵢₙ, Vₘₐₓ de repos et deux valeurs de consigne, associées aux valeurs de consigne de la tension Vₘᵢₙ, Vₘₐₓ de repos, d'états SOCₘᵢₙ, SOCₘₐₓ de charge, **caractérisé par** les stades suivants :
- (S1) interruption du courant (40), lorsque la valeur *V*₁, *V*₂ de tension respective est atteinte ;
- (S2) établissement de la tension respective de repos sur la base d'un comportement (41) respectif de décroissance de la tension induit par l'interruption du courant ;
- (S3) établissement d'une différence Δ*V*₁*,* Δ*V*₂ (42) respective de tension entre la tension respective au repos établie et sa valeur Vₘᵢₙ, Vₘₐₓ de consigne associée respectivement ;
- (S4) établissement d'une différence ΔSOC₁, ΔSOC₂ (43) d'état respective d'état de charge associée à la différence Δ*V*₁, Δ*V*₂ respective de tension ; et
- (S5) établissement du débit Δ*Q*' de charge en fonction de la différence Δ*Q* de charge détectée et des différences ΔSOC₁, ΔSOC₂ (43) d'état de charge établies.

2. Procédé suivant la revendication 1, **caractérisé en ce que** l'on établit le débit Δ*Q*' de charge au moyen d'un facteur *K* de correction suivant Δ*Q*' = Δ*Q*/*K*(ΔSOC₁, ΔSOC₂ | SOCₘₐₓ, SOCₘᵢₙ).

3. Procédé suivant la revendication 1 ou 2, **caractérisé en ce que** l'on établit le débit Δ*Q*' de charge au moyen de $Δ Q ′ = Δ Q / \left[1+\frac{Δ {SOC}_{1} - Δ {SOC}_{2}}{{SOC}_{max} - {SOC}_{min}}\right] .$

4. Procédé suivant l'une des revendications précédentes, **caractérisé en ce que** l'établissement des différences ΔSOC₁, ΔSOC₂ (43) d'état de charge s'effectue au moyen d'une ligne (13) caractéristique de tension de repos.

5. Procédé suivant l'une des revendications précédentes, **caractérisé en ce que** l'on établit les tensions de repos respectivement au moyen d'un ajustement du comportement (41) de décroissance.

6. Procédé suivant la revendication 5, **caractérisé en ce que** l'on utilise comme fonction d'ajustement *F*(*V*,*λ*|*t*) = *V*_{OCV} + (*v - V*_{OCV})exp (-Ât), dans lequel *V*_{OCV} caractérise la tension de repos respective à établir et *v*,*λ* sont d'autres paramètres d'ajustement.

7. Procédé suivant l'une des revendications précédentes, **caractérisé en ce que** l'on interrompt le courant sur un laps de temps de 1 à 60 secondes, de 1 à 30 secondes ou de 1 à 10 secondes.

8. Procédé suivant l'une des revendications précédentes, **caractérisé en ce que** l'élément de batterie est constitué sous la forme d'un élément de batterie aux ions lithium.

9. Procédé HPC pour un élément de batterie, dans lequel on établit au moins une durée de vie de l'élément de batterie, **caractérisé en ce que**, pour un établissement de la durée de vie, on établit une perte de capacité de l'élément de batterie en déterminant plusieurs fois un débit Δ*Q*' de charge suivant l'une des revendications précédentes.

10. Procédé HPC suivant la revendication 9, **caractérisé en ce que** l'on détermine en outre une autodécharge de l'élément de batterie.
